# EUROPEAN PATENT APPLICATION

(11) **EP 3 255 659 A1**
(43) Date of publication of application: **13.12.2017**
(21) Application number: 16761657.2
(22) Date of filing: 04.03.2016
(51) Int. Cl.: H01L 21/60, B23K 20/00

(54) **BONDING METHOD AND BONDED BODY**

(30) Priority: 06.03.2015 JP 2015045259
(71) Applicant: Mitsubishi Heavy Industries, Ltd., Tokyo 108-8215 (JP)
(72) Inventor: KATO Masahiro, Tokyo 108-8215 (JP); HARADA Shota, Tokyo 108-8215 (JP); ISAYAMA Takeshi, Tokyo 108-8215 (JP); FUJIEDA Mitsuteru, Tokyo 108-8215 (JP)
(74) Representative: Henkel, Breuer & Partner
(86) International application number: PCT/JP2016/056727
(87) International publication number: WO 2016/143687

(57) **Abstract**

This bonding method of a first member and a second member comprises: a step for forming a first wire bonding bump (12) on a first electrode (14) that is arranged on the first member; a step for forming a second wire bonding bump (22) on a second electrode 24 that is arranged on the second member; a step for forming a flat bump surface (221) by flattening a front end portion of the second wire bonding bump; and a compression bonding step for compression-bonding a front end portion (120) of the first wire bonding bump and the flat bump surface (221)with each other.

## Description

### Technical Field

The present invention relates to a bonding method and a bonded body.

### Background Art

A chip loaded substrate is known in which a chip is loaded on a substrate. When the chip loaded substrate is manufactured, chip electrodes and substrate electrodes are bonded by various methods. As the method of bonding the chip electrode and the substrate electrode, a method is known in which the chip electrode and the substrate electrode are bonded through a bump formed on at least one of the chip electrode and the substrate electrode.

As the related technique, Patent Literature 1 discloses that a film forming technique is used when a bump is to be formed on the electrode. The film forming technique is suitable for a mass production having an identical structure. On the other hand, the film forming technique does not sometimes suit to a small quantity production having a different structure.

### Citation List

[Patent Literature 1] JP 2005-243714A

### Summary of the Invention

An object of the present invention is to provide a method of bonding a first member and a second member, in which a positional deviation between the first member and the second member can be reduced in case of bonding the first member and the second member through wire bonding bumps, and a bonded body in which a positional deviation between the first member and the second member can be reduced.

A bonding method in some embodiments includes forming a first wire bonding bump (12) on a first electrode (14) arranged in a first member (10); forming a second wire bonding bump (22) on a second electrode (24) arranged in a second member (20); flattening a tip section (220) of the second wire bonding bump to form a bump flat surface (221); and pressure bonding a tip section (120) of the first wire bonding bump (12) and the bump flat surface (221) each other.

A bonded body in some embodiments is a bonded body formed by the above bonding method.

According to the present invention, there are provided with the method of bonding the first member and the second member, in which a positional deviation between the first member and the second member can be reduced in case of bonding the first member and the second member through the wire bonding bump, and the bonded body in which a positional deviation between the first member and the second member can be reduced.

### Brief Description of the Drawings

The attached drawings are incorporated into this Specification to help the description of embodiments. Note that the drawings should not be interpreted to limit the present invention to illustrated and described examples.
[FIG. 1] FIG. 1 is a perspective view schematically showing a substrate.
[FIG. 2] FIG. 2 is a perspective view schematically showing a chip loaded on the substrate.
[FIG. 3] FIG. 3 is a sectional view schematically showing a part of a bonding step of the substrate and the chip.
[FIG. 4A] FIG. 4A is a flow chart showing the bonding process of the substrate and the chip.
[FIG. 4B] FIG. 4B is a sectional view schematically showing the bonding process of the substrate and the chip.
[FIG. 4C] FIG. 4C is a sectional view schematically showing the bonding process of the substrate and the chip.
[FIG. 4D] FIG. 4D is a sectional view schematically showing the bonding process of the substrate and the chip.
[FIG. 5] FIG. 5 is a flow chart which explains the bonding method of the substrate and the chip.
[FIG. 6A] FIG. 6A is a perspective view schematically showing the bonding process of the substrate and the chip.
[FIG. 6B] FIG. 6B is a perspective view schematically showing the bonding process of the substrate and the chip.
[FIG. 6C] FIG. 6C is a sectional view schematically showing the bonding process of the substrate and the chip.
[FIG. 6D] FIG. 6D is a sectional view schematically showing the bonding process of the substrate and the chip.
[FIG. 6E] FIG. 6E is a sectional view schematically showing the bonding process of the substrate and the chip.
[FIG. 6F] FIG. 6F is a sectional view schematically showing the bonding process of the substrate and the chip.
[FIG. 6G] FIG. 6G is a sectional view schematically showing the bonding process of the substrate and the chip.
[FIG. 6H] FIG. 6H is a sectional view schematically showing the bonding process of the substrate and the chip.
[FIG. 6I] FIG. 6I is a sectional view schematically showing the bonding process of the substrate and the chip.
[FIG. 6J] FIG. 6J is a sectional view schematically showing the bonding process of the substrate and the chip.
[FIG. 6K] FIG. 6K is a sectional view schematically showing the bonding process of the substrate and the chip.
[FIG. 6L] FIG. 6L is a sectional view schematically showing the bonding process of the substrate and the chip.
[FIG. 6M] FIG. 6M is a sectional view schematically showing the bonding process of the substrate and the chip.
[FIG. 6N] FIG. 6N is a sectional view schematically showing the bonding process of the substrate and the chip.

### Description of the Embodiments

In the following detailed description, many detailed specific matters are disclosed for the purpose of the description to provide the comprehensive understanding of embodiments. However, it would be apparent that one or plural embodiments are executable without these detailed specific matters. Hereinafter, a bonding method and a bonded body will be described with reference to the attached drawings.

### (Definition of coordinate system)

A predetermined axis extending along a front surface of a first member (a surface to be bonded to a second member) or a back surface of the second member (a surface to be bonded to the first member) is defined as an X axis. An axis extending along the front surface of the first member or the back surface of the second member and perpendicular to the X axis is defined as a Y axis. An axis orthogonal to the X axis and the Y axis is defined as a Z axis.

### (Definition of important terms)

In this Specification, a "wire bonding bump" means a bump formed by wire bonding.

In this Specification, a "first wire bonding bump" means a wire bonding bump formed on an electrode of a first member.

In this Specification, a "second wire bonding bump" means a wire bonding bump formed on an electrode of a second member.

In this Specification, a "first member" is, for example, a substrate or a chip.

In this Specification, a "second member" is, for example, a substrate or a chip.

In this Specification, the first member and the second member may be respectively a substrate and another substrate, a substrate and a chip, a chip and a substrate, or the chip and another chip.

In this Specification, the first member may be a member except for the substrate and the chip. Also, the second member may be a member except for the substrate and the chip.

### (Matters recognized by inventors)

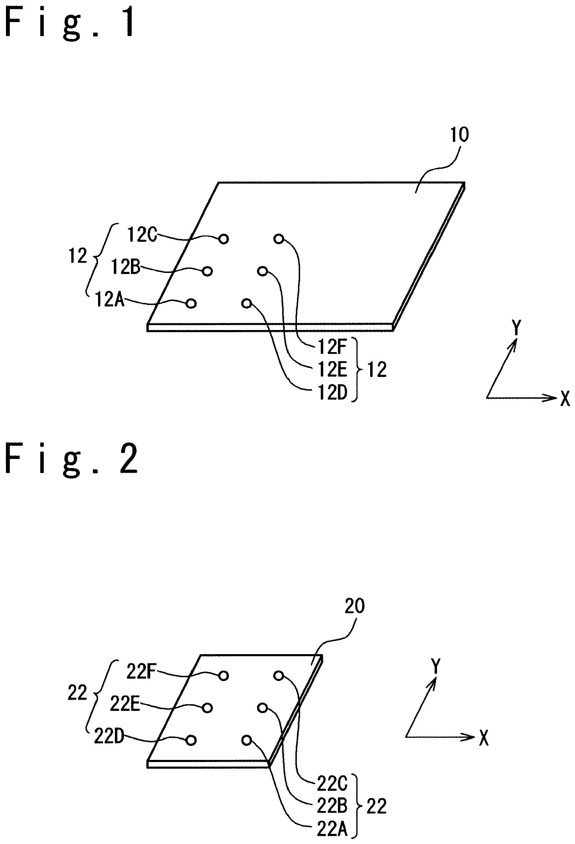

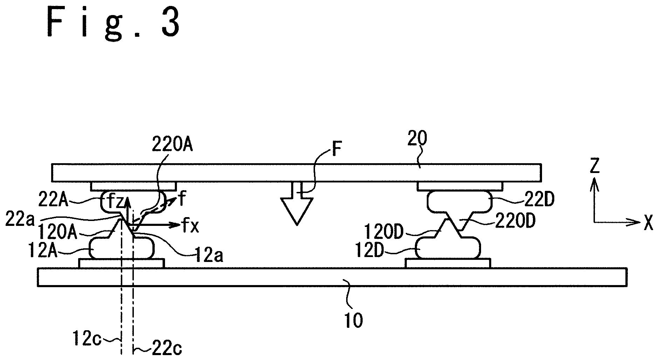

Referring to FIG. 1 to FIG. 3, the matters recognized by the inventors will be described. FIG. 1 is a perspective view schematically showing a substrate 10. FIG. 2 is a perspective view schematically showing a chip 20 to be loaded on the substrate. FIG. 3 is a sectional view schematically showing a part of a bonding process of the substrate 10 and the chip 20. Note that FIG. 1 to FIG. 3 are diagrams temporarily used to explain the matters recognized by the inventors. Therefore, FIG. 1 to FIG. 3 are not prior arts.

As shown in FIG. 1, the substrate 10 includes first wire bonding bumps 12 formed by the wire bonding technique.

As shown in FIG. 2, the chip 20 to be loaded on the substrate 10 includes second wire bonding bumps 22 formed by the wire bonding technique.

When the substrate 10 and chip 20 are to be bonded, it is assumed that a bump 12A, a bump 12B, a bump 12C, a bump 12D, a bump 12E, and a bump 12F on the substrate 10 are brought in contact with a bump 22A, a bump 22B, a bump 22C, a bump 22D, a bump 22E, a bump 22F on the chip 20, respectively.

As shown in FIG. 3, each of the wire bonding bumps (bump 12A and so on) of the substrate 10 has a tip section (tip section 120A and so on) protruding to an outward direction apart from the substrate 10. Also, each wire bonding bump (bump 22A and so on) of the chip 20 includes a tip section (tip section 220A and so on) protruding to the outward direction apart from the chip 20. FIG. 3 shows the tip section 120A of the first wire bonding bump 12A, the tip section 120D of the first wire bonding bump 12D, the tip section 220A of the second wire bonding bump 22A, and the tip section 220D of the second wire bonding bump 22D.

By applying force F onto the chip 20, the tip section 120A of the first wire bonding bump 12A and the tip section 220A of the second wire bonding bump 22A are brought into contact with each other. As the reaction to the force which acts on a contact surface 12a of the first wire bonding bump 12A, force f is applied onto a contact surface 22a of the second wire bonding bump 22A. The chip 20 having the second wire bonding bump 22A is moved to a positive direction of the X axis by the X axial direction component Fx of the force f. As a result, the difference between the central axis 12c of the first wire bonding bump 12A and the central axis 22c of the second wire bonding bump 22A increases.

As mentioned above, the inventors recognized that the positional deviation between the substrate and the chip increases when connecting the substrate and the chip through the wire bonding bumps.

### (Overview of method of bonding first member and second member)

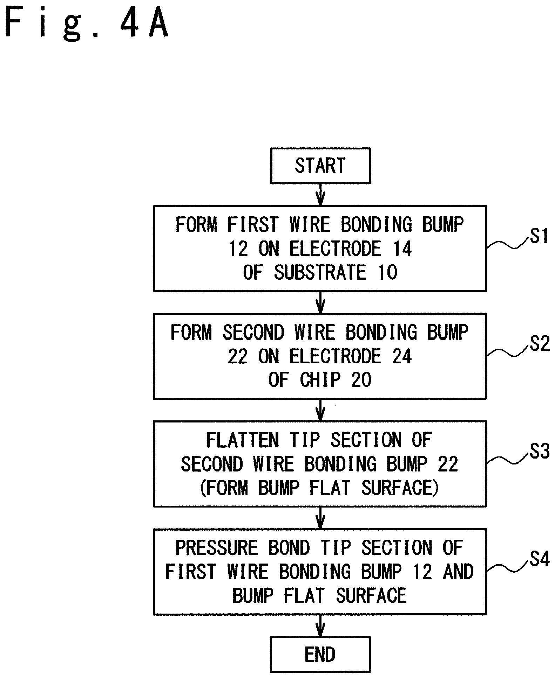

Referring to FIG. 4A to FIG. 4D, the overview of the bonding method of the first member and the second member according to an embodiment will be described. Note that to make the description easy to understand, an example that the first member is the substrate 10 and the second member is the chip 20 will be described in the following description (using FIG. 4A to FIG. 4D). Therefore, when the first member is a member except for the substrate, the "substrate" should be read as a "first member" in the following description. Also, when the second member is a member except for the chip, the "chip" should be read as a "second member" in the following description.

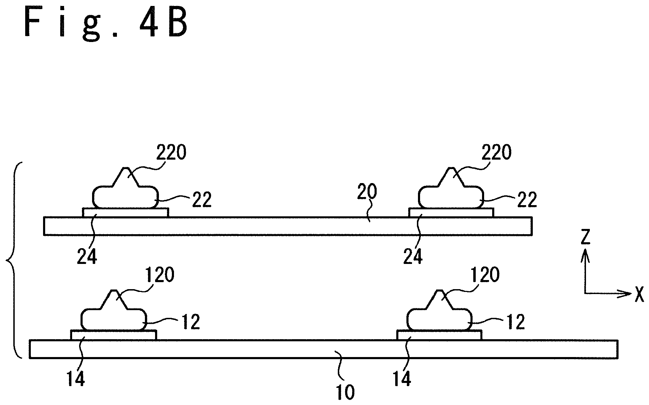

FIG. 4A is a flow chart showing the bonding process of the substrate 10 and the chip 20. Also, FIG. 4B to FIG. 4D are sectional views schematically showing the bonding process of the substrate 10 and the chip 20.

As shown in FIG. 4A and FIG. 4B, at a first step S1, the first wire bonding bumps 12 are formed on first electrodes 14 (substrate electrodes) arranged on the substrate 10. Note that the number of electrodes 14 on the substrate 10 and the number of wire bonding bumps 12 formed on the electrodes 14 are optional.

In the lower-side part of FIG. 4B, the substrate 10 after the first wire bonding bumps 12 are formed is shown. The first wire bonding bump 12 has the tip section 120 protruding in the outward direction apart from the substrate 10.

By the general characteristic of the wire bonding technique, the positions where the first wire bonding bumps 12 are formed are possible to set freely. For this reason, even if the substrates are of various kinds and of small quantity production, it is relatively easy to form the first wire bonding bump 12 on the electrode 14 of the substrate 10.

As shown in FIG. 4A and FIG. 4B, at a second step S2, the second wire bonding bumps 22 are formed on the second electrodes 24 (the chip electrode) arranged on the chip 20. Note that the number of electrodes 24 on the chip 20 and the number of wire bonding bumps 22 formed on the electrodes 24 are optional.

In the upper-side part of FIG. 4B, the chip 20 after the second wire bonding bumps 22 are formed is shown. The second wire bonding bump 22 has the tip section 220 protruding in the outward direction apart from the chip 20.

By the general characteristic of the wire bonding technique, the positions where the second wire bonding bumps 22 are formed are possible to set freely. For this reason, even if the chips 20 are of various kinds and of small quantity production, it is relatively easy to form the second wire bonding bumps 22 on the electrodes 24 of the chip 20.

Note that the second step S2 may be executed before the first step S1.

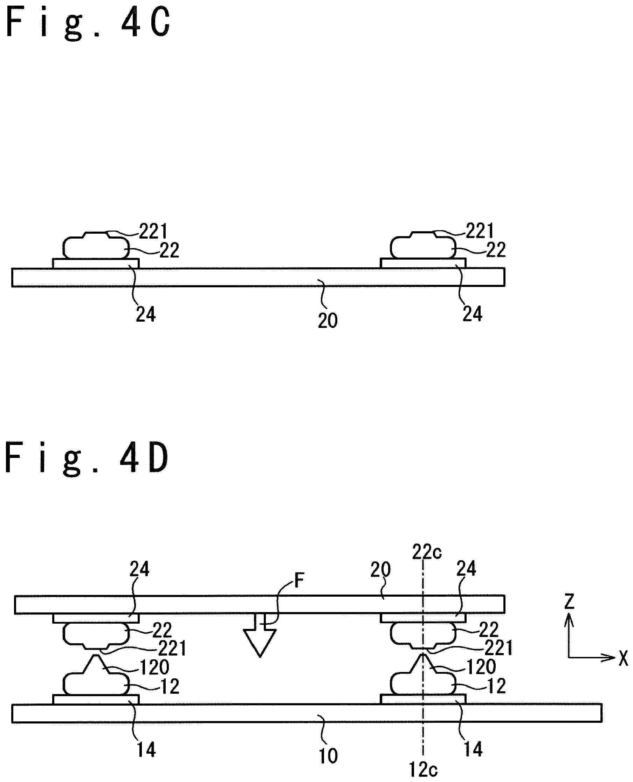

As shown in FIG. 4A and FIG. 4C, at a third step S3, the tip section of the second wire bonding bump 22 is flattened. By the flattening, a bump flat surface 221 is formed in the second wire bonding bump 22 .

Note that the third step S3 is executed after the second step S2. Also, the third step S3 is executed before the first step S1 or after the first step S1.

As shown in FIG. 4A and FIG. 4D, at a fourth step S4, the tip section 120 of the first wire bonding bump 12 and the bump flat surface 221 are pressure bonded.

In an example shown in FIG. 4D, by moving the chip 20 (in other words, by acting the force F on the chip 20), the first wire bonding bump 12 and the second wire bonding bump 22 are pressure bonded to each other. Alternatively or additionally, by moving the substrate 10, the first wire bonding bump 12 and the second wire bonding bump 22 may be pressure bonded to each other.

Note that the fourth step S4 is executed after the first step S1 to the third step S3.

An example shown in FIG. 4A to FIG. 4D contains a step of flattening the tip sections of the second wire bonding bumps 22. Therefore, when the first wire bonding bumps 12 and the second wire bonding bumps 22 are pressure bonded to each other, the positional deviation of the central axis 12c of the first wire bonding bump 12 and the central axis 22c of the second wire bonding bump 22 does not increase.

As a result, the positional deviation between the substrate and the chip can be reduced, compared with a case that the tip section of the bump is not flattened.

Note that in the example shown in FIG. 4D, the tip section of the first wire bonding bump (the tip section 120 in the example shown in FIG. 4D) is not flattened before the first wire bonding bump 12 and the second wire bonding bump 22 are pressure bonded to each other. In other words, it is only the second wire bonding bump 22 that the flattening of the tip section is carried out at the third step S3.

Therefore, when the first wire bonding bump 12 and the second wire bonding bump 22 are to be pressure bonded to each other, it is possible to increase a plane pressure acting on the bonding surface of the first wire bonding bump and the bonding surface of the second wire bonding bump (especially, at an initial step of the pressure bonding). As a result, the bonding strength between the first wire bonding bump and the second wire bonding bump increases. Or, the first wire bonding bump and the second wire bonding bump can be pressure bonded to each other in a smaller load.

In an example shown in FIG. 4A to FIG. 4D, the substrate 10 and the chip 20 are pressure bonded through the first wire bonding bumps 12 on the substrate side and the second wire bonding bumps 22 on the chip side. Therefore, by using the first wire bonding bump 12 and the second wire bonding bump 22 having a comparatively thicker thickness as a buffering material or a cushion, it is restrained for the substrate 10, the substrate electrode 14, the chip 20 and the chip electrode 24 to be damaged by the pressure acting in the bonding.

### (More detailed description of method of bonding first member and second member)

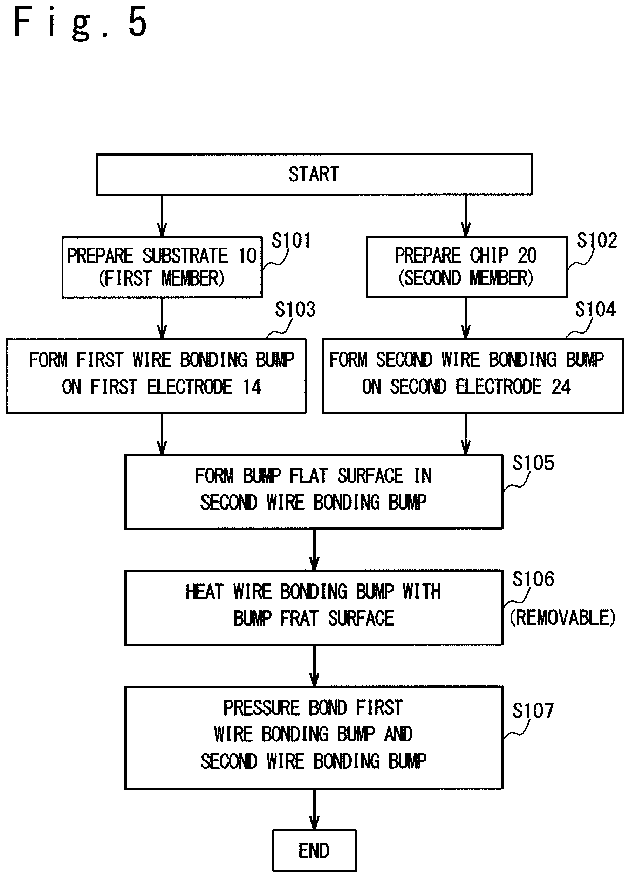

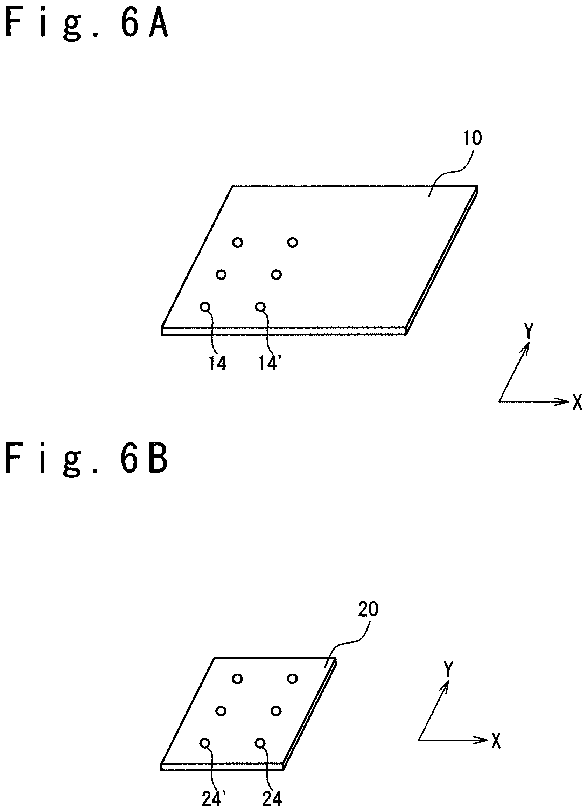

Referring to FIG. 5 to FIG. 6N, a bonding method of the first member and the second member according to the embodiment will be described in detail. Note that to make the description easy to understand, a case where the first member is the substrate 10 and the second member is the chip 20 will be described in the following description (the description with reference to FIG. 5 to FIG. 6N). Therefore, when the first member is a member except for the substrate, the "substrate" should be read as the "first member" in the following description. Also, when the second member is a member except for the chip, the "chip" should be read as the "second member" in the following description.

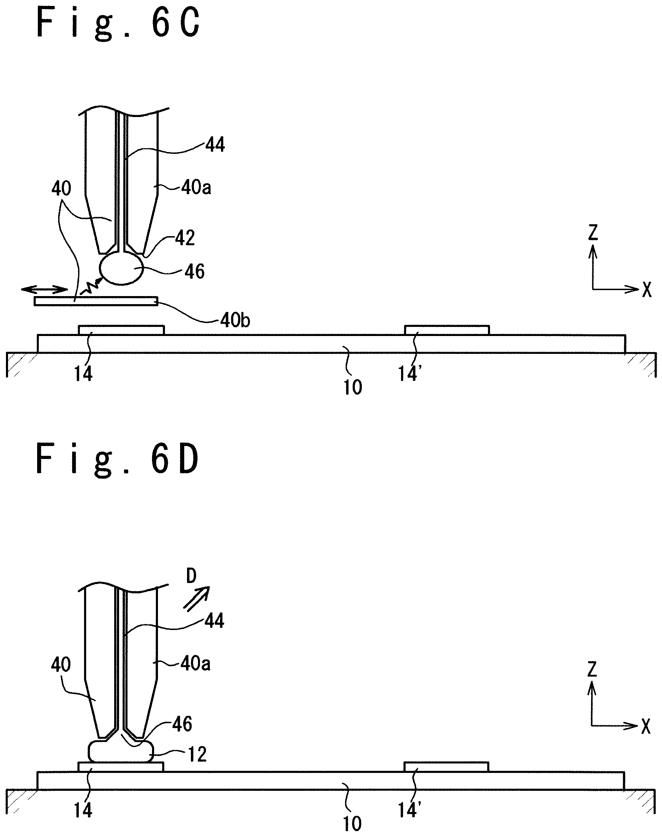

FIG. 5 is a flow chart to describe the bonding method of the substrate and the chip. The FIG. 6A and FIG. 6B are perspective views schematically showing the bonding process of the substrate 10 and the chip 20. FIG. 6C to FIG. 6N are sectional views schematically showing the bonding process of the substrate 10 and the chip 20. Note that in FIG. 5 to FIG. 6N, the same reference numeral is assigned to a member which has the same function as the member shown in FIG. 4A to FIG. 4D. Regarding the member having an identical reference numeral, the repetitive description is omitted.

At a first step S101, the substrate 10 having a plurality of substrate electrodes is prepared. For example, the substrate electrode configures a part of a circuit formed in the substrate. The thickness of the substrate electrode is, for example, equal to or less than 1 µm. Also, the material of the substrate electrode contains gold or aluminum. The material of the substrate 10 contains silicon (in other words, the substrate 10 is a silicon substrate). FIG. 6A shows the substrate 10 prepared at the first step S101. In the following description, one electrode arranged on the substrate 10 is referred to as a first electrode 14 and another electrode arranged on the substrate 10 is referred to as a third electrode 14'.

At a second step S102, the chip 20 having a chip electrode is prepared. For example, the chip electrode configures a part of a circuit formed in the chip. The thickness of the chip electrode is equal to or less than 1 µm. Also, the material of the chip electrode contains gold or aluminum. The chip 20 is a semiconductor chip. The chip 20 is a memory, a CPU, a sensor, an analog circuit, MEMS or combinations of them. FIG. 6B shows the chip 20 prepared at the second step S102. In the following description, one electrode arranged on the chip 20 is referred to as a second electrode 24, and another electrode arranged on the chip 20 is referred to a fourth electrode 24'.

At a third step S103, the first wire bonding bump 12 is formed on the first electrode 14 of the substrate 10. The third step S103 is executed after the first step S101. FIG. 6C to FIG. 6E are sectional views schematically showing the state in which the third step S103 is executed.

Referring to FIG. 6C to FIG. 6E, a step of forming the first wire bonding bump 12 on the first electrode 14 in the left half of the substrate 10 will be described.

In FIG. 6C, a wire bonding apparatus 40 is shown. As the wire bonding apparatus 40, a known apparatus may be used. The wire bonding apparatus 40 is movable, for example, to an optional three-dimensional direction (a direction along the X axis, a direction along the Y axis and a direction along the Z axis). For example, the wire bonding apparatus 40 includes a main unit section 40a and a discharge electrode 40b. The material 44 of a linear shape (wire-like shape) is accommodated in the main unit section 40a. The material 44 is accommodated in the main unit section 40a so as to be drawable from the opening formed in an end section 42 of the main unit section 40a. The material 44 is a material to form the wire bonding bump. For example, the material 44 contains gold (Au).

The discharge electrode 40b is an electrode to discharge for the material 44 drawn out from the opening formed in the end section 42. The discharge electrode 40b is electrically connected with a high-volt power supply (not illustrated). The discharge is caused based on a difference between the potential of the discharge electrode 40b and the potential of the material 44. The material 44 fuses due to the energy of the discharge. As a result, a spherical body 46 in the fusion state is formed in the tip of the material 44. Note that the discharge electrode 40b may be configured to be relatively moveable to the main unit section 40a between an advanced position where the discharge electrode 40b faces the end section 42 of the main unit section 40a and a recessed position where it does not face the end section 42 of the main unit section 40a. After forming of the spherical body 46, the discharge electrode 40b is moved back to the recessed position.

After the discharge electrode 40b is moved back, the wire bonding apparatus 40 (the main unit section 40a) moves to the first electrode 14 in the left part of the substrate 10. Typically, the wire bonding apparatus 40 (the main unit section 40a) moves to the direction along the Z axial direction. As the result of movement of the wire bonding apparatus 40 (the main unit section 40a), the spherical body 46 in the fusion state is brought in contact with the first electrode 14 in the left part of the substrate 10.

FIG. 6D shows the state when the spherical body 46 has been brought in contact with the first electrode 14. In the state shown in FIG. 6D, the first wire bonding bump 12 (the spherical body 46 after change of the shape) is brought in contact with the first electrode 14, and the first wire bonding bump 12 is connected with the material 44 of the linear shape. It is assumed that the wire bonding apparatus 40 (the main unit section 40a) is moved from the state shown in FIG. 6D to a diagonally upward direction to the substrate 10 (for example, a direction shown by an arrow D). In other words, when the wire bonding apparatus 40 moves to the outward direction apart from the substrate 10, the wire bonding apparatus 40 moves to the direction along the surface of the substrate 10, (a direction along the surface of the substrate 10 and heading for the third electrode 14').

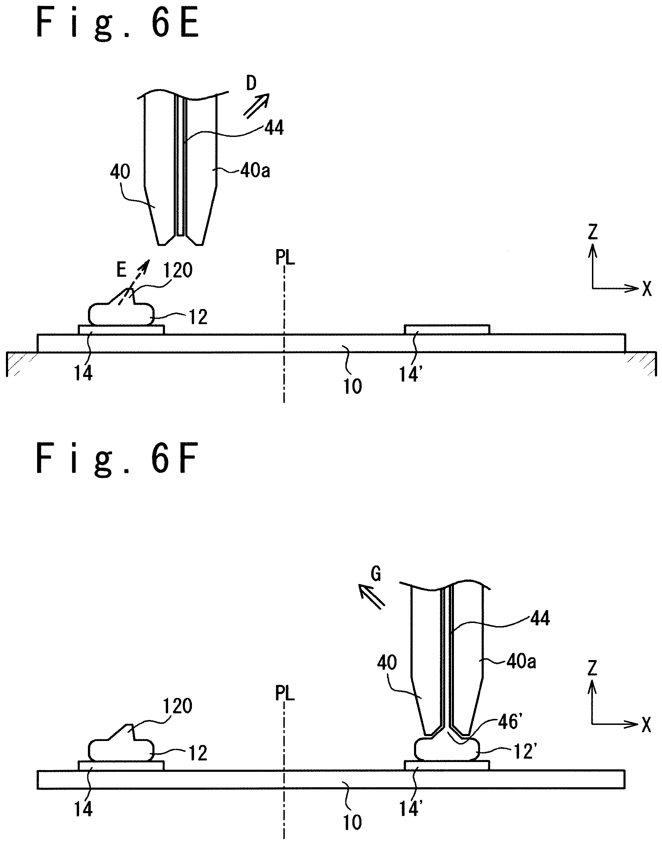

FIG. 6E shows the state after the wire bonding apparatus 40 is moved diagonally upward to the substrate 10. The material 44 having the linear shape is cut by the movement of the wire bonding apparatus 40. Also, as the result of the cutting, the tip section 120 is formed in the first wire bonding bump 12 to protrude to the outward direction apart from the substrate 10.

Note that in an example shown in FIG. 6E, the tip section 120 is inclined to the direction to which the third electrode 14' is located (inclined to the direction shown by the arrow E from the direction perpendicular to the substrate 10). The step of forming the first wire bonding bump contains a step of cutting the material of the first wire bonding bump 12 so that the tip section 120 of the first wire bonding bump is inclined to the direction to which the third electrode 14' is located (it is because the step of forming the first wire bonding bump contains a step of cutting the material 44 of the wire bonding bump 12 by moving the wire bonding apparatus 40 to the direction shown by the arrow D to the substrate 10).

In the example shown in FIG. 6E, it can be said that the tip section 120 is inclined to the direction heading for the plane PL which passes a halfway point between the first electrode 14 and the third electrode 14' and which is perpendicular to a segment which links the first electrode 14 and the third electrode 14'.

At the third step S3, a plurality of wire bonding bumps are respectively formed on a plurality of electrodes (for example, all electrodes) arranged on the substrate 10. For example, a third wire bonding bump is formed on the third electrode 14' arranged on the substrate 10. The step of forming the third wire bonding bump is similar to the step of forming the first wire bonding bump 12 until the step of pressure bonding the spherical body to the electrode. Therefore, only the step of cutting the third wire bonding bump will be described.

FIG. 6F shows the state after the spherical body 46' (the spherical body after change of the shape) is brought in contact with the third electrode 14'. In the state shown in FIG. 6F, the third wire bonding bump 12' (the spherical body 46' after change of the shape) is brought in contact with the third electrode 14', and the third wire bonding bump 12' is in the state that it is connected with the material 44 having the linear shape. It is assumed that the wire bonding apparatus 40 (the main unit section 40a) is moved diagonally upward to the substrate 10 from the state shown in FIG. 6F (for example, a direction shown by the arrow G). In other words, when the wire bonding apparatus 40 is moved to the outward direction apart from the substrate 10, the wire bonding apparatus 40 is moved to the direction along the surface of the substrate 10, (the direction along the surface of the substrate 10 and heading for the first electrode 14).

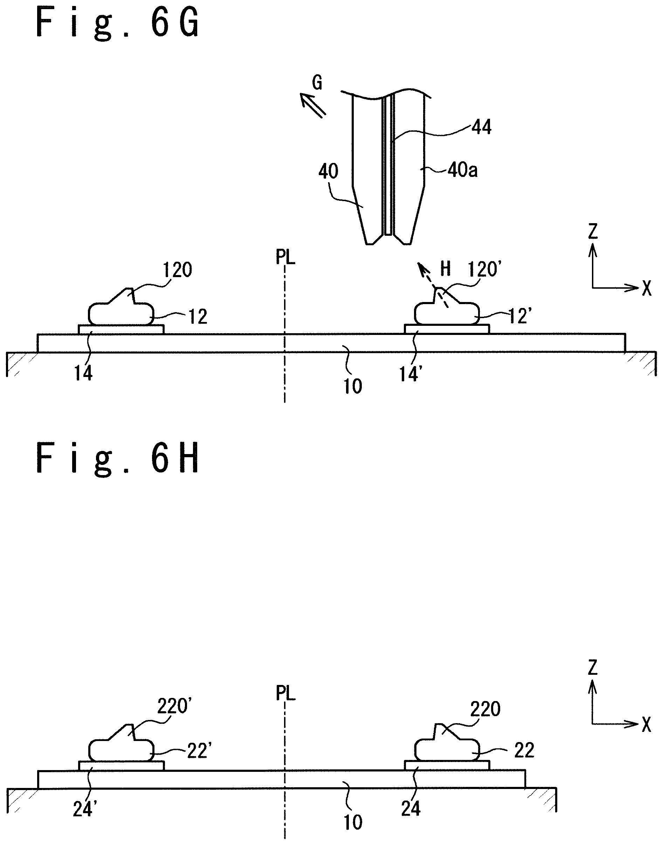

FIG. 6G shows the state after the wire bonding apparatus 40 is moved diagonally upward to the substrate 10. The material 44 having the linear shape is cut by the movement of the wire bonding apparatus 40. Also, as the result of the cutting, the tip section 120' is formed in the third wire bonding bump 12' to protrude to the outward direction apart from the substrate 10.

Note that in the example shown in FIG. 6G, the tip section 120' is inclined to the direction to which the first electrode 14 is located (inclined to the direction shown by the arrow H from the direction perpendicular to the substrate 10). This is because the step of forming the third wire bonding bump contains a step of cutting the material of the third wire bonding bump 12' so that the tip section 120' of the third wire bonding bump is inclined to the direction to which the first electrode 14 is located (this is because containing a step of cutting the material 44 of the wire bonding bump by moving the wire bonding apparatus 40 to the direction shown by the arrow G to the substrate 10).

In the example shown in FIG. 6G, it can be said that the tip section 120' is inclined to the direction heading for the plane PL which passes a halfway point between the first electrode 14 and the third electrode 14' and which is perpendicular to a segment linking the first electrode 14 and the third electrode 14'.

As above, at the step of forming the third wire bonding bump 12', the orientation of the tip section 120' of the third wire bonding bump 12' (for example, the direction of the central axis of the tip section 120') is different from the orientation of the tip section 120 of the first wire bonding bump 12 (for example, the direction of the central axis of the tip section 120). More specifically, the tip section 120' and the tip section 120 are inclined to face each other.

Alternatively, the tip section 120' and the tip section 120 may be inclined the directions apart from each other. That is, the step of forming the first wire bonding bump may contain a step of cutting the material of the first wire bonding bump 12 so that the tip section 120 of the first wire bonding bump is inclined to a direction opposite to the direction to which the third electrode 14' is located, and the step of forming the third wire bonding bump may contain a step of cutting the material of the third wire bonding bump 12' so that the tip section 120' of the third wire bonding bump 12' is inclined to a direction opposite to the direction which the first electrode 14 is located.

By the third step S103, a plurality of wire bonding bumps of a desired number are respectively formed on a plurality of electrodes arranged on the substrate 10.

At a fourth step S104, a second wire bonding bump 22 is formed on the second electrode 24 of the chip 20. The fourth step S104 is a step to be executed after the second step S102. The step of forming the second wire bonding bump 22 on the second electrode 24 of the chip 20 is similar to the step of forming the first wire bonding bump 12 on the first electrode 14 of the substrate 10. Therefore, the repetitive description is omitted. Note that, for example, in the description of the third step S103, if the "substrate 10", the "first electrode 14", the "third electrode 14'", the "first wire bonding bump 12", and the "tip section 120" are read as the "chip 20", the "second electrode 24", the "fourth electrode 24'", the "second wire bonding bump 22", and the "tip section 220", respectively, the description of the step of forming the second wire bonding bump 22 is given.

FIG. 6H shows the state after the second wire bonding bump 22 is formed on the second electrode 24 of the chip 20 at the fourth step S104, and the fourth wire bonding bump 22' is formed on the fourth electrode 24'. By the fourth step S104, the plurality of wire bonding bumps of the desired number are formed on the plurality of electrodes arranged on the chip 20, respectively.

Note that the first step S101 and the third step S103 may be executed before the second step and the fourth step S104, or may be executed after the second step and the fourth step S104, or may be executed simultaneously with the second step and the fourth step S104, respectively. After the execution of the first step S101 to the fourth step S104, a fifth step S105 is executed.

The fifth step S105 is a step of forming a bump flat surface. In the fifth step S105, the tip section of the second wire bonding bump 22 is flattened. In other words, at the fifth step S105, a bump flat surface is formed in the second wire bonding bump. In the following description, an example that a bump flat surface is formed in the second wire bonding bump 22 will be described.

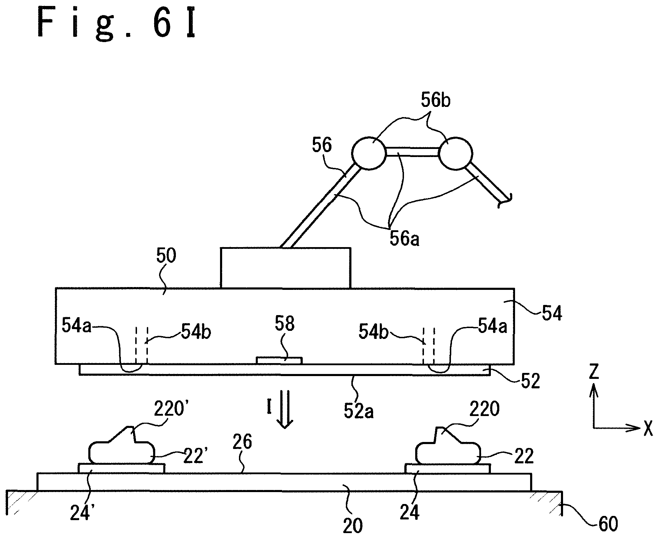

Referring to FIG. 6I, the fifth step S105 will be described. A flat surface forming apparatus 50 is shown in FIG. 6I. The flat surface forming device 50 includes a pushing member 52 which pushes the tip section 220 of the second wire bonding bump 22, a pushing block 54 which holds the pushing member 52, and a pushing member moving mechanism 56 (or a pushing block moving mechanism). The flat surface forming apparatus 50 may include a pressure sensor 58.

The pushing member 52 has a flat surface 52a which contacts the tip section 220 of the second wire bonding bump 22. For example, the pushing member 52 is a board-like (specifically, tabular) member. The pushing member 52 is a silicon board (more specifically, a silicon flat board). In other words, the pushing member 52 is formed of the silicon material. For example, the silicon board is a board in which an oxide film is a formed on the surface of the silicon material. By using the silicon board as the pushing member 52 (in other words, by using the surface of the silicon board as the flat surface 52a of the pushing member 52), it is possible to remarkably improve the plane degree of the flat surface 52a cheaply and easily, as compared with a case of using a glass board as the pushing member 52.

For example, when a silicon board is used as the pushing member 52, the silicon board has the thickness of 0.05 mm to 1 mm.

The pushing block 54 is a member which holds the pushing member 52. For example, the pushing block 54 holds the pushing member 52 detachably. By making the pushing member 52 detachable to the pushing block 54, it is possible to easily exchange the pushing member 52 when the flatness of the flat surface 52a of the pushing member 52 is declined. In the example shown in FIG. 6I, the pushing block 54 has an absorption hole 54a to absorb the pushing member 52 and a pipe route 54b communicating with the absorption hole 54a. The pipe route 54b is connected with a suction pump and so on (not illustrated). When the pushing block 54 holds the pushing member 52 by the vacuum absorption detachably, the exchange of the pushing member 52 becomes easier.

The pushing member moving mechanism 56 is a mechanism to move the pushing member 52 relatively to the chip 20 arranged on a stage 60. The pushing member moving mechanism 56 may have, for example, a driver (not illustrated), arm members 56a, and pivot sections 56b. The pushing member moving mechanism 56 may move the pushing member 52 (and the pushing block 54) only in the direction along the Z axis (in other words, the direction perpendicular to the chip back surface 26). Alternatively, the pushing member moving mechanism 56 may move the pushing member 52 (and the pushing block 54) to an optional direction in the three-dimensional space. The pushing member moving mechanism 56 moves the pushing member 52 for the tip section 220 of the second wire bonding bump. The pushing member 52 is moved so that the tip section 220 of the second wire bonding bump 22 is brought in contact with the flat surface 52a of the pushing member 52. The pushing member 52 is moved so that the tip section 220 of the second wire bonding bump 22 are flattened by the pushing member 52.

Note that in the example shown in FIG. 6I, the pushing member 52 is moved to a direction shown by the arrow I (in other words, the pushing member 52 is moved downwardly for the chip 20), to crush the tip section 220 of the second wire bonding bump 22 and to flatten the tip section 220 of the second wire bonding bump 22. Alternatively, the stage 60 to support the chip 20 may be lifted up for the pushing member 52 to crush the tip section 220 of the second wire bonding bump 22 and to flatten the tip section 220 of the second wire bonding bump 22.

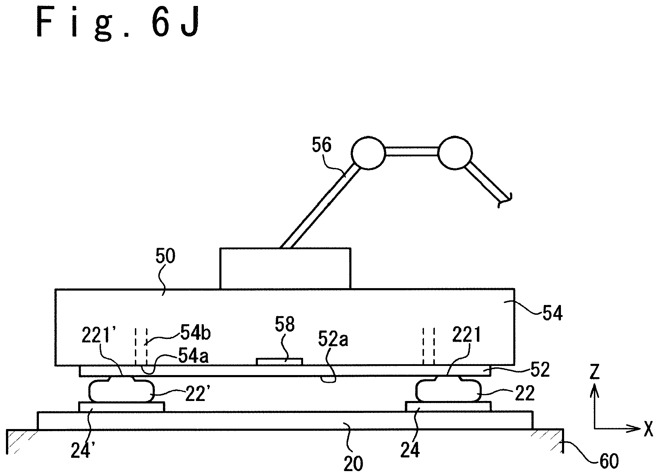

FIG. 6J show the state after the tip section 220 of the second wire bonding bump 22 is flattened. By the flattening, the bump flat surface 221 is formed in the second wire bonding bump. Note that in the example shown in FIG. 6I and FIG. 6J, the tip sections of all the wire bonding bumps on the electrodes arranged on the chip 20 are crushed at a same time (in other words, the bump flat surfaces (the bump flat surface 221, the bump flat surface 221' and so on) are formed at a same time to all the wire bonding bumps). Therefore, the time taken to form the bump flat surfaces is shortened.

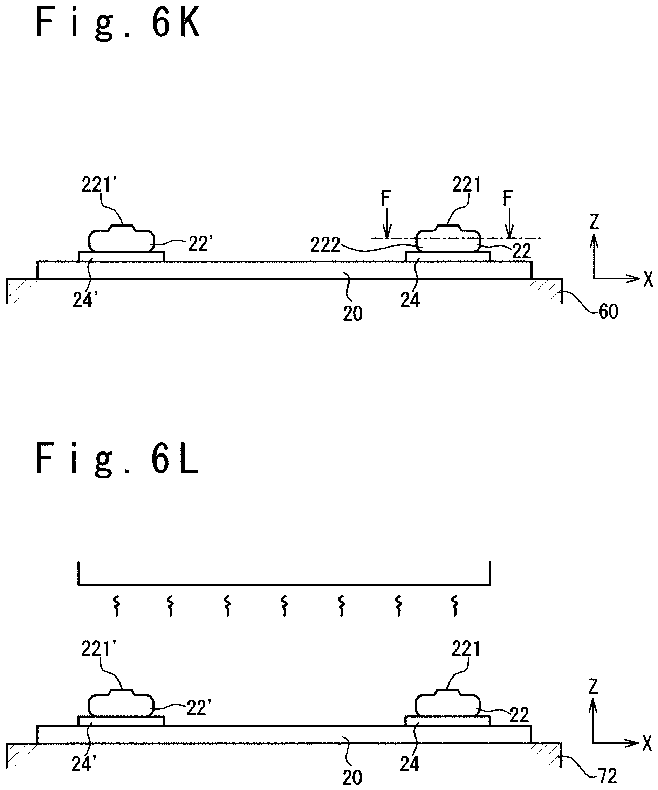

FIG. 6K is a schematic sectional view showing the bump flat surface 221 formed by the fifth step S105. In FIG. 6K, the sectional view viewed from the direction of the F-F arrows is a sectional view, in which the area of the second wire bonding bump 22 is maximum, of sectional views parallel to the bump flat surface 221 of the second wire bonding bump 22. In FIG. 6K, the area of the bump flat surface 221 is, for example, 30% or more and 90% or below of the area of the second wire bonding bump 22 viewed from the direction of the F-F arrow.

The tip section 220 of the second wire bonding bump 22 is crushed so that the area of the bump flat surface 221 is equal to or more than 30% of the maximum cross section area of the second wire bonding bump 22 (the cross section area in the sectional view viewed from the direction of the F-F arrow). As a result, the situation that the area of the bump flat surface 221 becomes too little can be avoided. Also, the tip section 220 of the second wire bonding bump 22 is crushed so that the area of the bump flat surface 221 is less than 90% of the maximum cross section area of the second wire bonding bump 22 (the cross section area in the sectional view viewed from the direction of the F-F arrow). As the result, the situation that the proximal section 222 of the second wire bonding bump 22 (a part other than the tip section 220) is crushed too much can be avoided.

Note that a total area of the bump flat surfaces (a summation of areas of the bump flat surfaces) is correlated with, for example, the pressure which acts on the pushing block 54. Therefore, if the pressure which acts on the pushing block 54 is measured by the pressure sensor 58 arranged on (the surface of) the pushing block 54 and the pushing member moving mechanism 56 is controlled based on the measured pressure, it is possible to control the total area of the bump flat surfaces.

Note that in FIG. 6K, the maximum cross section area of the second wire bonding bump 22 (the cross section area viewed from the direction of the F-F arrows) is, for example, equal to or more than 2.5 × 10⁻¹¹πm², and equal to or less than 1.0×010⁻⁸πm². Also, the area of the bump flat surface 221 is, for example, equal to or more than 7.5×10⁻¹²πm², and equal to or less than 9.0×10⁻⁹πm².

A sixth step S106 is a heating step of heating the flattened wire bonding bump. At the sixth step S106, the second wire bonding bump is heated such that the second wire bonding bump having the bump flat surface becomes hotter than the first wire bonding bump.

Referring to FIG. 6L, the sixth step S106 will be described. In the example shown in FIG. 6L, the sixth step S106 is executed after execution of the fifth step S105 and before execution of the following seventh step S107. The stage 72 as a heater is shown in FIG. 6L. For example, the stage 72 has the heater. In the example shown in FIG. 6L, the chip 20 is supported by the stage 72. Here, the arranging of the heater is not limited to an example shown in FIG. 6L and is optional.

The heater heats the flattened second wire bonding bump 22 to a temperature below the melting point of the bump. The heater heats the flattened second wire bonding bump 22 to, for example, a temperature of 100 °C or above and of 250 °C or below. The flattened second wire bonding bump 22 is softened through the heating. Note that the sixth step (the heating step) may be incorporated into the fifth step. For example, if the heater is incorporated into the pushing block 54 shown in FIG. 6I and FIG. 6J, the fifth step (the step of forming the bump flat surface) and the sixth step can be executed at the same time. Alternatively, the sixth step (the heating step) may be incorporated into the following seventh step. For example, if the heater is incorporated into the holding block to hold the chip 20, the seventh step and the sixth step can be executed at the same time.

Note that sixth step S106 may be omitted.

The seventh step S107 is a pressure bonding step of pressure-bonding the first wire bonding bump and the second wire bonding bump. The seventh step is executed after the fifth step S105.

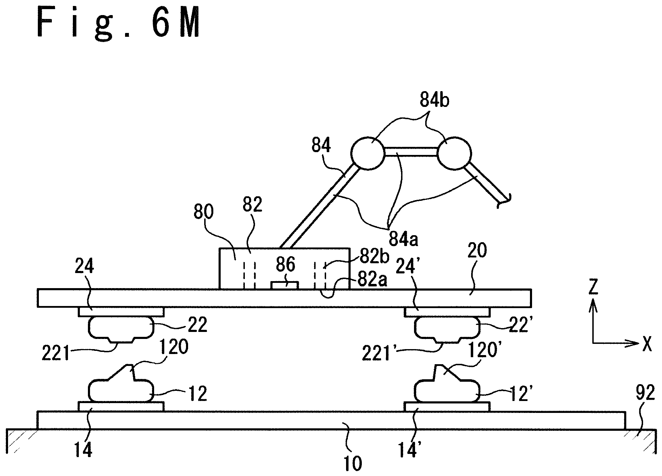

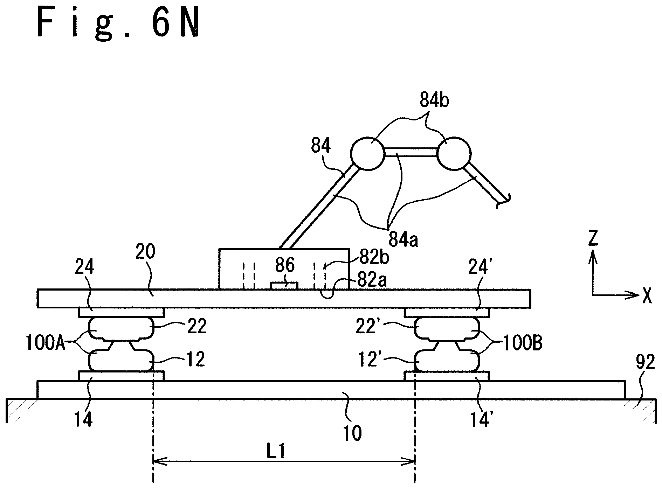

Referring to FIG. 6M and FIG. 6N, the seventh step S107 will be described. FIG. 6M shows a pressure bonding apparatus 80. For example, the pressure bonding apparatus 80 includes a holding block 82 and a holding block moving mechanism 84. The pressure bonding apparatus 80 may have a pressure sensor 86.

The holding block 82 is a holding member for holding the chip 20. In the example shown in FIG. 6M, the holding block 82 has an absorption hole 82a to absorb the chip 20 and a pipe route 82b communicating with the absorption hole 82a. The pipe route 82b is connected with a suction pump and so on (not illustrated). In the example shown in FIG. 6M, the holding block 82 holds the chip 20 detachably by the vacuum absorption.

The holding block moving mechanism 84 is a mechanism for moving the holding block 82 relatively to the substrate 10 arranged on the stage 92. The holding block moving mechanism 84 may include, for example, a driver (not illustrated), arm members 84a and pivot sections 84b. The holding block moving mechanism 84 may be able to move the holding block 82 only to the direction along the Z axis (in other words, the direction perpendicular to the front surface 16 of the substrate 10). Alternatively, the holding block moving mechanism 84 may be able to move the holding block 82 to an optional three-dimensional optional direction. The holding block moving mechanism 84 moves the holding block 82 toward the tip section 120 of the first wire bonding bump 12. By moving the chip 20 together with the holding block 82, the tip section 120 of the first wire bonding bump 12 is brought in contact with the bump flat surface 221 of the second wire bonding bump 22. By moving the chip 20 together with the holding block 82, the tip section 120 of the first wire bonding bump 12 sticks the bump flat surface 221 of the second wire bonding bump 22. By moving the chip 20 together with the holding block 82, the tip section 120 of first wire bonding bump 12 and the bump flat surface 221 of the second wire bonding bump are pressure bonded to each other.

Note that referring to the description of the above-mentioned third step S103 and FIG. 6M, the tip section 120 of the first wire bonding bump 12 and the tip section 120' of the third wire bonding bump 12' are inclined to directions to face each other. Therefore, the relative movement of the substrate 10 and the chip 20, such as movement to the X direction, is constrained when the first wire bonding bump 12 and the second wire bonding bump 22 are pressure bonded and the third wire bonding bump 12' and the fourth wire bonding bump 22' are pressure bonded. As a result, the generation of the positional deviation is effectively restrained in case of bonding of the substrate 10 and the chip 20.

Note that the generation of the positional deviation is effectively restrained even in case of bonding the substrate 10 and the chip 20, when the tip section 120 of the first wire bonding bump 12 and the tip section 120' of the third wire bonding bump 12' are inclined to be apart from each other.

Note that when the second wire bonding bump 22 having the bump flat surface 221 is softened at the sixth step (the heating step), a sticking quantity of the tip section 120 of the first wire bonding bump 12 to the bump flat surface 221 increases. As the result of increasing of the sticking quantity, the bonding strength between the wire bonding bumps increases. Also, when the second wire bonding bump 22 having the bump flat surface 221 is softened at the sixth step (the heating step), it is possible to pressure bond the tip section 120 of the first wire bonding bump 12 and the bump flat surface 221 of the second wire bonding bump with a relatively small pressuring force. Therefore, it is restrained that the substrate 10, the substrate electrode 14, the chip 20 and the chip electrode 24 are damaged in the pressure bonding.

Note that a total of pushing pressures acting on each bump flat surface is correlated with the magnitude of the pressure acting on the holding block 82. Therefore, if the pressure acting on the holding block 82 is measured by the pressure sensor 86 arranged on (the surface of) the holding block 82, and the holding block moving mechanism 84 is controlled based on the measured pressure, it is possible to control the magnitude of the pushing pressure acting on the bump flat surface.

FIG. 6N shows the state after execution of the seventh step S107. In the state after the execution of the seventh step S107, the substrate 10 and the chip 20 are bonded through the first wire bonding bump 12 and the second wire bonding bump 22. Also, the substrate 10 and the chip 20 are bonded through the third wire bonding bump 12' and the fourth wire bonding bump 22'. Thus, the substrate 10 and the chip 20 forms one bonded body.

In an example shown in FIG. 6N, the distance L1 between one bonded wire bonding bump 100A and another neighbor bonded wire bonding bump 100B is, for example, from 1 µm to 1000 µm, 10 µm to 1000 µm, 1 µm to 100 µm, or 10 µm to 100 µm. By adopting the bonding method of the substrate and the chip shown in FIG. 5 to FIG. 6N, it is possible to shorten the distance between the bonded wire bonding bumps neighbor to each other. Therefore, it becomes possible to load the chips on the substrate in a high density.

The examples shown in FIG. 5 to FIG. 6N provide the same advantageous effects as in the example shown in FIG. 4A to FIG. 4D. Also, in the examples shown in FIG. 5 to FIG. 6N, when the pushing member 52 is a silicon board, it is possible to improve the flatness of the bump flat surface which has been formed through the contact with the pushing member 52. In the examples shown in FIG. 5 to FIG. 6N, when the bonding method of the substrate and the bumps contains the step of heating the wire bonding bump having the bump flat surface, the first wire bonding bump and the second wire bonding bump can be bonded by using the relatively small pushing pressure.

The present invention is not limited to each of the above embodiments, and it would be apparent that each embodiment may be changed or modified appropriately in the range of the technique thought of the present invention. Various techniques used in each embodiment and each modification example can be applied to the other embodiments or the other modification examples, unless the technical contradiction occurs.

The present application is based on Japanese Patent Application No. 2015-45259 which was filed on March 6, 2015, and claims a priority based on the application. The disclosure thereof is incorporated herein by reference.

## Claims

1. A bonding method comprising:
forming a first wire bonding bump on a first electrode arranged in a first member;
forming a second wire bonding bump on a second electrode arranged in a second member;
flattening a tip section of the second wire bonding bump to form a bump flat surface; and
pressure bonding the tip section of the first wire bonding bump and the bump flat surface.

2. The bonding method according to claim 1, wherein the tip section of the first wire bonding bump is not flattened before the pressure bonding.

3. The bonding method according to claim 1 or 2, wherein the flattening includes flattening the tip section of the second wire bonding bump by bringing the tip section of the second wire bonding bump in contact with a flat surface of a pushing member, and
wherein the flat surface of the pushing member is a surface of a silicon board.

4. The bonding method according to any one of claims 1 to 3, further comprising:
heating the second wire bonding bump such that the second wire bonding bump becomes hotter than the first wire bonding bump,
wherein the pressure bonding includes pressure bonding the tip section of the first wire bonding bump and the bump flat surface of the second wire bonding bump softened by the heating.

5. The bonding method according to any one of claims 1 to 4, further comprising:
forming a third wire bonding bump on a third electrode arranged in the first member,
wherein the tip section of the first wire bonding bump formed in the forming the first wire bonding bump and the tip section of the third wire bonding bump formed in the forming the third wire bonding bump are inclined to face each other.

6. The bonding method according to any one of claims 1 to 4, further comprising:
forming a third wire bonding bump on a third electrode arranged in the first member,
wherein the tip section of the first wire bonding bump formed in the forming the first wire bonding bump and the tip section of the third wire bonding bump formed in the forming the third wire bonding bump are inclined to be apart from each other.

7. A bonded body formed by the bonding method according to any one of claims 1 to 6.

8. The bonded body according to claim 7, wherein a distance between a bonded wire bonding bump formed by bonding the first wire bonding bump and the second wire bonding bump and another bonded wire bonding bump is in a range of 1 µm to 1000 µm.

## Amended claims

### Amended claims under Art. 19.1 PCT

1. (Original)
A bonding method comprising:
forming a first wire bonding bump on a first electrode arranged in a first member;
forming a second wire bonding bump on a second electrode arranged in a second member;
flattening a tip section of the second wire bonding bump to form a bump flat surface; and
pressure bonding the tip section of the first wire bonding bump and the bump flat surface.

2. (Original)
The bonding method according to claim 1,
wherein the tip section of the first wire bonding bump is not flattened before the pressure bonding.

3. (Original)
The bonding method according to claim 1 or 2, wherein the flattening includes flattening the tip section of the second wire bonding bump by bringing the tip section of the second wire bonding bump in contact with a flat surface of a pushing member, and
wherein the flat surface of the pushing member is a surface of a silicon board.

4. (Original)
The bonding method according to any one of claims 1 to 3, further comprising:
heating the second wire bonding bump such that the second wire bonding bump becomes hotter than the first wire bonding bump,
wherein the pressure bonding includes pressure bonding the tip section of the first wire bonding bump and the bump flat surface of the second wire bonding bump softened by the heating.

5. (Original)
The bonding method according to any one of claims 1 to 4, further comprising:
forming a third wire bonding bump on a third electrode arranged in the first member,
wherein the tip section of the first wire bonding bump formed in the forming the first wire bonding bump and the tip section of the third wire bonding bump formed in the forming the third wire bonding bump are inclined to face each other.

6. (Original)
The bonding method according to any one of claims 1 to 4, further comprising:
forming a third wire bonding bump on a third electrode arranged in the first member,
wherein the tip section of the first wire bonding bump formed in the forming the first wire bonding bump and the tip section of the third wire bonding bump formed in the forming the third wire bonding bump are inclined to be apart from each other.

7. (Original)
A bonded body formed by the bonding method according to any one of claims 1 to 6.

8. (Original)
The bonded body according to claim 7, wherein a distance between a bonded wire bonding bump formed by bonding the first wire bonding bump and the second wire bonding bump and another bonded wire bonding bump is in a range of 1 µm to 1000 µm.

9. (New)
The bonding method according to any one of claims 1 to 6, wherein a material of the first wire bonding bump and a material of the first wire bonding bump are identical to each other.
